# EUROPEAN PATENT APPLICATION

(11) **EP 1 156 519 A1**
(43) Date of publication of application: **21.11.2001**
(21) Application number: 00110456.1
(22) Date of filing: 16.05.2000
(51) Int. Cl.: H01L 21/3213

(54) **Gate etch process for 12 inch wafers**

(71) Applicant: Semiconductor 300 GmbH & Co. KG, 01099 Dresden (DE)
(72) Inventor: Morgenstern, Thomas, 01109 Dresden (DE); Grewal, Virinder, 85560 Ebersberg (DE)
(74) Representative: Hermann, Uwe, Dipl.-Ing.

(57) **Abstract**

A method for fabricating a stacked gate array on a semiconductor 12 inch wafer uses a reaction chamber with an upper inductive means and a lower capacitive means. For etching 12 inch wafers the etching parameters are adjusted to values optimised for etching an 8 inch wafer. In particular the power of the upper inductive means is set to a value between 50 and 600 Watts.

## Description

### Field of the Invention

The present invention relates to the fabrication of integrated circuits and more particularly to a method for fabricating a stacked gate array on a wafer with a diameter of 12 inch.

### Background of the Invention

The transition to 12 inch wafer size requires new equipment for the fabrication of integrated circuits. In particular, there is a need to provide new etching machines which are able to etch patterns on these wafers with high quality.

US 5,591,301 A discloses a method of plasma etching a gate stack on silicon. The method uses a reaction chamber fitted with an electrically conductive planar coil disposed outside the reaction chamber and adjacent to a dielectric window mounted in a wall of the reaction chamber. The conductive planar coil is coupled to a first radio frequency source. The reaction chamber further comprises a wafer support mounted in the reaction chamber in a direction parallel to the planar coil and coupled to a second radio frequency source. The power applied to the planar coil is set to 1 to 200 Watts and the power applied to the substrate support is limited to 50 to 200 Watts during etching. The prior art method provides good etch rates and selectivity and prevents undercutting of gate stacks during etching.

US 5,529,197 discloses a method in which a reaction chamber is used to etch a wafer with a diameter of 8 inch. The reaction chamber is provided with a top inductive coil and a bottom electrode, both connected to radio frequency sources. The power of the top coil of the reaction chamber is preferably adjusted to between 0 and 200 Watts. The power of the bottom electrode of the reaction chamber is preferably adjusted to between 50 and 200 Watts. After the wafer to be etched is placed into the reaction chamber the reaction chamber is evacuated down to between 5 milli-Torr and 15 milli-Torr. Etching gases are then fed into the reaction chamber and the coil and electrode are then energised to convert these etching gases into plasma. The etching operation is performed in a single step and provides an etch ratio of approximately 1:1 for the materials of the gate stack. The uniformity of the etch is better than 5%. The resulting rate of etching on the above stated conditions is approximately 250nm/min. The low power etching method provides gate stacks without undercutting or notching.

Currently suitable etching methods are needed for processing wafers with a diameter of more than 12 inch. It is a commonly held belief in the art that the etch parameters optimised for an 8 inch process cannot be ported without changes to a 12 inch process. This commonly held belief in the art can, for example, be found in Sanjay Tandon, Challenges for 300mm Plasma Etch System Development, Semiconductor International, March 1998, page 75. According to this commonly held belief the power coupled into the plasma must be scaled by the scaling factor of the increased etch area.

Therefore the power coupled to the plasma should be increased by a factor of 2.4 to 2.7.

It is therefore an object of the present invention to provide an optimised process for etching gate stack arrays on 12 inch wafers.

### Summary of the Invention

The invention provides a method for fabricating a stacked gate array on a semiconductor wafer with a diameter of more than 8 inch. The method includes providing a reaction chamber, having an upper inductive means and a lower capacitive means. The power settings of the upper inductive means are adjusted to obtain a uniformity better than 10% in etching a wafer with a diameter of 8 inch at a rate of etching between 50 and 500 nm/min. Then a wafer with a diameter of more than 8 inch is placed into the reaction chamber and is etched to provide the stacked gate array.

According to the invention the parameter optimised for an 8 inch process can be ported to a 12 inch process without changes. Therefore there is no need to apply any scaling laws.

In particular TCP and DPS etching machines can be used without changes to the etching parameters for etching 12 inch wafers.

### Brief Description of the Drawings

For a detailed understanding of the present invention reference should be made to the following detailed description taken in conjunction with accompanying drawings, wherein:
- Figure 1: is a cross section of a stacked gate array before etching;
- Figure 2: is a cross section of a stacked gate array after etching;
- Figure 3: is a cross section of a DPS reaction chamber; and
- Figure 4: is a cross section of a TCP reaction chamber.

### Detailed Description of the Invention

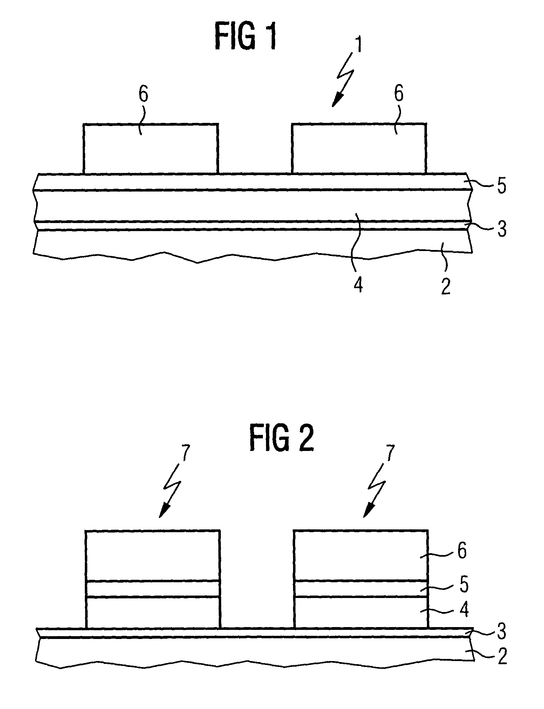

The present invention described in detail herein is directed towards a method for anisotropically etching multi-layer gate structures. Figure 1 shows a multi-layer sequence of a gate array 1 before etching. Such stacked gate arrays 1 are frequently implemented in Dynamic Random Access Memories (DRAM). The multi-layered sequence of the stacked gate array 1 comprises a substrate 2 which is covered by an oxide layer 3. Usually the substrate 2 is made of silicon and the oxide layer 3 is made of silicon oxide. Above the oxide layer 3 there is a polysilicon layer which is in turn covered by a metal layer 5 made of silicides such as, for example, WSi or TiSi. Finally a mask layer 6 is provided, usually made of nitrids such as SiN. The mask layer 6 is patterned by means of a photoresist not shown in figure 1. The mask layer 6 is used to pattern the underlaying metal layer 5 and polysilicon layer 4 in an etching process.

The result of the etching process is shown in figure 2. The metal layer 5 and the polysilicon layer 4 have been etched in order to provide the array 1 comprising various gate stacks 7.

The etching process must fulfil several demands. In particular no changes of critical dimensions (CD) may occur. Therefore the etching process may not result in notching or undercutting. In particular the polysilicon layer 4 may not be undercut in order to maintain the critical gate width. Furthermore the etching process must be uniform over the area of the wafer. Therefore uniformity is required to be less than 10%, preferably 5% over the area of the wafer. The term uniformity is one of the key parameter well known in the art. In determining the uniformity the thickness of the residual oxide layer 3 is measured on 49 places on the wafer. Then the unifomity calculates according to the formula: uniformity equals maximum thickness minus minimum thickness divided by two times the mean value.

A further requirement is the safe stopping of the etching process on the oxide layer 3. In current processes the thickness of the oxide layer 3 amounts to about 8 nm and there is a tendency to further reduce the thickness of the oxide layer 3. As an undamaged oxide layer is necessary for the electrical isolation of the polysilicon layer against a channel in the substrate 2 the etching process must stop safely on the oxide layer.

Finally, for economical reasons the throughput should be as high as possible. This requirement implies a high etching speed during the etching process.

One way to fulfil this requirement is to use a chemical physical dry etching process. In such a process etching is performed by adsorption of etching gas particles on the surface of the material to be etched. The etching gas particles chemically react with atoms of the material to be etched. Finally a desorption process takes place. In particular, ions impinging on the surface to be etched transfer the kinetic energy on the reaction product such that the reaction products are able to depart from the surface of the material to be etched.

For etching the gate stacks 7 the etching gas must contain components which are able to react with the materials used for the gate stack 7. Consequently the etching gas used for etching the metal 5 made of a silicide contains HCl, Cl₂ and NF₃. For etching the polysilicon layer 4 the etching gas contains gases like HCl, Cl₂ and O₂. When the oxide layer 3 is approached these gas components are replaced by HBr and O₂ or Cl₂ and O₂ in order to reduce the etching rate and to provide a safe stopping on the oxide layer 3.

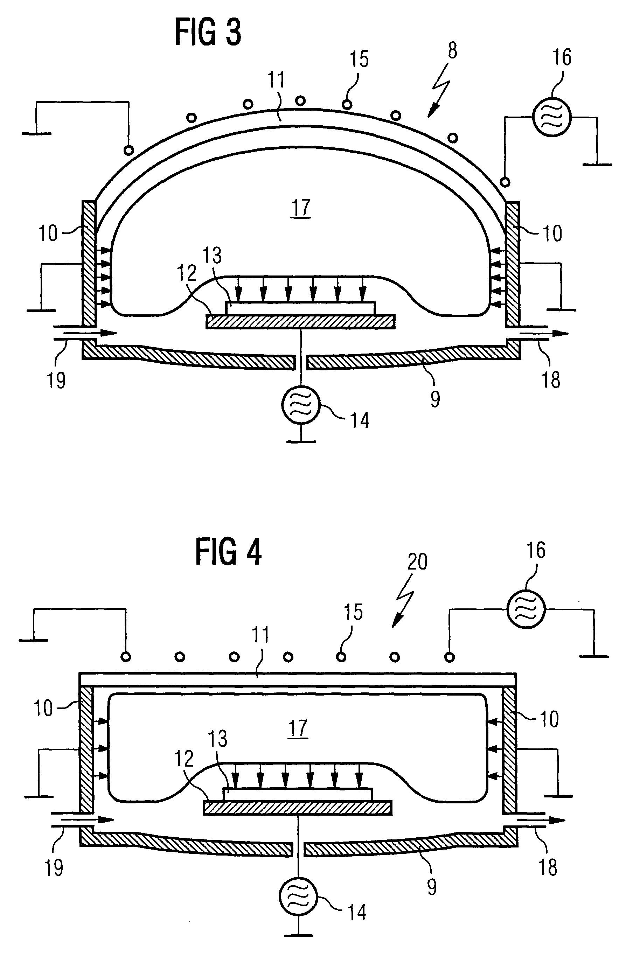

Figure 3 shows a DPS reaction chamber in which the etching process is carried out. The acronym DPS is well known in the art and stands for Decoupled Plasma Source. It designates etching machines built by LAM Research, Fremont, California.

The DPS reaction chamber 8 comprises a bottom wall 9 and is domed by an upper wall 11. A bottom electrode 12 supporting a wafer 13 is placed parallel to the bottom wall 9. The bottom electrode 12 is coupled to a first radio frequency source which supplies a radio frequency with a power of 0 to 200 Watts to the bottom electrode 12. The side wall 10 is grounded. The DPS reaction chamber 8 further comprises a coil 15 above the domed upper wall 11. The coil 15 is connected to a second radio frequency source 16 that supplies a radio frequency with a power between 150 and 600 Watts to the coil 15. The domed upper wall 11 is made of a dielectric material such as Al₂O₃. Consequently, the magnetic field produced by the coil can enter the reaction chamber and induce currents in a plasma 17 contained in the DPS reaction chamber.

Due to the higher mobility of electrons the bottom electrode 12 is negatively charged against the plasma 17 so that positively charged ions contained in the plasma 17 are accelerated in the direction of the bottom electrode 12. The ions impinging on the wafer 13 drive the reactions by deposing their kinetic energy at the surface of the wafer 13. Furthermore, desorption of the reaction products takes place. The reaction products are removed from the DPS reaction chamber 8 by an exhaust 18 and are replaced by a new etching gas fed into the DPS reaction chamber by an inlet 19.

Figure 4 shows a cross section of a TCP reaction chamber. The term TCP is an acronym well known in the art and stands for Transformator Coupled Plasma. It designates etching machines manufactured by Applied Materials, Santa Clara, California.

The TCP reaction chamber 20 differs from the DPS reaction chamber 8 by the shape of the upper wall 11. The TCP reaction chamber 20 is provided with a flat upper wall. The distance between the bottmom electrode 12 and the upper coil is 16 centimeter. In TCP reaction chambers for 8 inch wafers the distance used to be 12 centimeter. The volume of the TCP reaction chamber 20 amounts to 74 liter in contrast to 35 liter for conventional TCP reaction chambers for 8 inch wafers. Accordingly the volume of the TCP reaction chamber 20 is smaller than the volume of the DPS reaction chamber 8. Consequently, less power is needed for energising the plasma 17. In particular the coil 15 of the TCP reaction chamber 20 is fed by a radio frequency with a power between 50 and 300 Watts.

Surprisingly it has turned out that the same etching parameters can be used for etching 12 inch wafers as for etching 8 inch wafers. In particular the power supplied to the coils 15 can be left unchanged in order to fulfil the requirements mentioned above. This is mainly due to the fact that the etching process is basically chemically driven. For maintaining a high etching rate it is therefore sufficient to supply enough etching gas particles which can be adsorbed to the surface of the material to be etched and to supply ions with a kinetic energy high enough to drive the chemical reaction and the desorption of the reaction products from the surface of the material to be etched.

These conditions can be met by operating the DPS reaction chamber 8 and the TCP reaction chamber 20 at etching parameters which do not depend on the size of the wafer to be etched. Therefore the DPS reaction chamber 8 and the TCP reaction chamber 20 can be operated in etching 12 inch wafers at the conditions for etching 8 inch wafer. Table 1 contains a detailed example for an etching process using the DPS reaction chamber 8:

| | time | Ws | b | press. | HCI | HeO₂ | NF₃ | CI₂ | BSP | Tc | Tw |
|---|---|---|---|---|---|---|---|---|---|---|---|
| | s | W | W | mTorr | sccm | sccm | sccm | sccm | Torr | C | C |
| WSiₓ | 17 | 500 | 160 | 4 | 40 | 3 | 40 | 150 | 5-20 | 25 | 65 |
| Poly | EP≈27 | 500 | 160 | 4 | 120 | 20 | | 30 | | 20-40 | |
| OE | 90 | 150 | 35 | 3fix | | 50 | | 60 | | | |
| OE: Overetch | | | | | | | | | | | |
| Ws: Source Power | | | | | | | | | | | |
| Wb: Bias Power | | | | | | | | | | | |
| BSC: Backside pressure | | | | | | | | | | | |
| Tc: Cathode temperature | | | | | | | | | | | |
| Tw: Wall temperature | | | | | | | | | | | |

The etching process in table 1 comprises a first step of etching WSiₓ during 17 seconds. The step is followed by etching the polysilicon layer 4 for about 27 seconds until the endpoint is reached. Finally some overetching takes place for about 90 seconds.

## Claims

1. A method for fabricating a stacked gate array on a semiconductor wafer with a diameter of more than 8 inch comprising the steps of:
- Providing a reaction chamber having an upper inductive means and a lower capacitive means;
- Adjusting power settings of said upper inductive means for obtaining a uniformity better than 10% in etching a wafer with a diameter of 8 inch at a rate of etching between 50 and 500 nm/min;
- Placing said wafer with a diameter of more 8 inch into said reaction chamber; and
- Plasma etching said wafer with a diameter of more than 8 inch to provide said stacked gate array.

2. The method according to claim 1, wherein
said stacked gate array comprises a layer of polysilicon on a layer of oxide.

3. The method according to claim 1, wherein
said stacked gate array comprises a layer of polysilicon, a layer of tungsten-silicon and a layer of oxide.

4. The method according to claim 1, wherein
said stacked gate array comprises a layer of polysilicon, a layer of titanium-silicon and a layer of oxide.

5. The method according to claim 1, wherein
said step of plasma etching comprises the steps of:
- Feeding at least one etching gas into said reaction chamber;
- Energising said inductive and capacitive means to convert the etching gas into a plasma to etch said wafer.

6. The method according to claim 5, wherein
the gas flow, the pressure and the temperature of said etching gas is such that said adsorption rate is bigger than a desorption rate of gas particles on a surface of said wafer.

7. The method according to claim 5, wherein
further the method comprises the step of recreating said reaction chamber before said step of plasma etching.

8. The method according to claim 5, wherein
said etching gas comprises at least one gas of the group HCl, Cl₂, NF₃, O₂ and HBr.

9. The method according to claim 1, wherein
said power of said upper inductive means is adjusted to between 50 and 600 Watts.

10. The method according to claim 1, wherein
said power of said lower capacitive means is adjusted to between about 0 and 200 Watts.

11. The method according to claim 1, further comprising
the step of adjusting said lower capacitive means to a power setting of less than 300 Watts.

12. The method according to claim 11, wherein
said power of said upper inductive means is adjusted to between 50 and 600 Watts and said power of said lower capacitive means is adjusted to between 0 and 200 Watts.

13. The method according to claim 1, wherein
the power of said upper inductive means is adjusted to obtain a uniformity of better than 5% in etching a wafer with a diameter of 8 inch at a rate of etching between 200 and 400 nm/min.
